# EUROPÄISCHE PATENTANMELDUNG

(11) **EP 2 384 843 A2**
(43) Veröffentlichungstag der Anmeldung: **09.11.2011**
(21) Anmeldenummer: 11164087.6
(22) Anmeldetag: 28.04.2011
(51) Int. Cl.: B23K 1/00, B23K 1/06, B23K 3/06

(54) **Verfahren und Vorrichtung zum Aufbringen von Lot auf ein Werkstück**

(30) Priorität: 05.05.2010 DE 102010016814
(71) Anmelder: SCHOTT Solar AG, 55122 Mainz (DE)
(72) Erfinder: Von Campe, Hilmar, 61352 Bad Homburg (DE); Meyer, Stefan, 63549 Ronneburg (DE); Huber, Stephan, 83562 Rechtmehring (DE)
(74) Vertreter: Stoffregen, Hans-Herbert

(57) **Zusammenfassung**

Die Erfindung bezieht sich auf ein Verfahren und eine Vorrichtung zum Aufbringen von Lot auf eine Solarzelle (10), wobei unter Verwendung eines Lotdrahts dieser im geschmolzenen Zustand auf die Solarzelle unter Einwirkung von von einer Sonotrode (18) applizierten Ultraschallschwingungen aufgebracht wird. Um überaus präzise das Lot auf die Solarzelle aufbringen zu können, ohne dass die Solarzelle unerwünscht hohen Temperaturen ausgesetzt wird, ist vorgesehen, dass der Lotdraht einem zwischen einer Heizeinrichtung (16, 17) und der die Ultraschallschwingungen applizierenden Sonotrode (18) verlaufenden Spalt (24) zugeführt und geschmolzen wird und durch den Spalt auf die Solarzelle (10) fließt.

## Beschreibung

Die Erfindung bezieht sich auf ein Verfahren zum Aufbringen von Lot auf ein Werkstück, vorzugsweise auf ein Halbleiterbauelement wie Solarzelle, wobei unter Verwendung eines Lotdrahtes Lot in geschmolzenem Zustand auf das Werkstück unter Ultraschalleinwirkung aufgebracht wird. Ferner bezieht sich die Erfindung auf eine Vorrichtung zum Aufbringen eines Lots auf ein Werkstück, insbesondere auf ein Halbleiterbauelement wie Solarzelle, umfassend eine Lotdrahtzuführungseinrichtung, eine Heizeinrichtung für den Lotdraht, eine Ultraschallsonotrode sowie eine Transporteinrichtung zum Transport des Werkstücks relativ sowohl zu der Heizeinrichtung als auch der Ultraschallsonotrode, wobei der Lotdraht in einer der Heizeinrichtung zugeordneten Heizzone geschmolzen wird.

Aus der WO-A-2008/014900 (DE-A-10 2006 035 626) ist ein Verfahren zum Anbringen eines Verbindungsleiters an einer Solarzelle bekannt, bei dem ein Lot mittels Ultraschalllöten auf die Solarzelle aufgebracht wird. Hierzu wird das Lot in Form eines Lotdrahts oder von Lotformteilen mittels einer Ultraschallsonotrode bei Löttemperatur aufgelötet.

Das Auflöten von Lot auf insbesondere Solarzellen mittels Ultraschall zeigt den Vorteil, dass ein Flussmittel nicht benutzt werden muss, wodurch anderenfalls die Gefahr einer Beschädigung der Solarzelle erwächst. Durch die Ultraschalleinwirkung werden auf den Solarzellen vorhandene Oxidschichten aufgebrochen, um eine mechanisch feste und elek-trisch gut leitende Verbindung zwischen dem Lot und der entsprechenden Metallschicht der Solarzelle sicherzustellen. Dies ist insbesondere dann von Vorteil, wenn es sich bei der Metallschicht um eine Aluminiumschicht wie ein aus Aluminium bestehender Rückseitenkontakt handelt.

Entsprechende Ultraschalllötverfahren sind z. B. auch der US-B-6,357,649 oder der Literaturstelle Mardesich et al.: "A Low-Cost Photovoltaic Cell Process Based on Thick Film Techniques; 14th IEEE PV, Sp.Conf. Proc., 1980, Seiten 943 - 947, zu entnehmen.

Der vorliegenden Erfindung liegt die Aufgabe zu Grunde, ein Verfahren und eine Vorrichtung der eingangs genannten Art so weiterzubilden, dass überaus präzise das Lot auf das Werkstück aufgebracht wird, ohne dass das Werkstück unerwünscht hohen Temperaturen ausgesetzt wird.

Zur Lösung der Aufgabe wird verfahrensmäßig im Wesentlichen vorgeschlagen, dass der Lotdraht einem zwischen einer Heizeinrichtung und einer Ultraschallschwingungen erzeugenden Sonotrode verlaufenden Spalt zugeführt, in dem Spalt geschmolzen wird und durch den Spalt auf das Werkstück fließt.

Abweichend vom Stand der Technik wird das Lotmaterial nicht durch eine Heizeinrichtung geführt und sodann über eine Öffnung abgegeben, um unter Ultraschalleinwirkung das Werkstück zu beloten, das auch als Auflöten bezeichnet werden kann. Vielmehr wird der Lotdraht einem seitlich freien Spalt zugeführt, wobei die Breite des Spaltes durch den Abstand zwischen Heizeinrichtung und Sonotrode vorgegeben wird. Dabei ist der Spalt zwischen der Sonotrode und der Heizeinrichtung vorzugsweise derart ausgelegt, dass dieser eine Breite aufweist, die vorzugsweise zwischen etwa ½ D ≤ B ≤ D mit D = Durchmesser des Lotdrahtes ist.

Erfindungsgemäß wird nicht nur die Heizeinrichtung auf eine Temperatur oberhalb der Schmelztemperatur des Lotdrahtes erwärmt, sondern auch die Sonotrode, wobei eine Temperatureinstellung unabhängig voneinander erfolgt.

Da der Spalt von der in Längsschwingung erregten Sonotrode begrenzt wird, wird ungeachtet der hohen Oberflächenspannung, die das geschmolzene Lot aufweist, dieses durch den Spalt hindurch gezogen. Insoweit übt der Spalt in etwa eine Kapillarwirkung aus.

Durch die diesbezügliche Maßnahme ergibt sich insbesondere auch der Vorteil, dass dem Grunde nach zum Beloten von Werkstücken, insbesondere Solarzellen, übliche Lotmaterialien zum Einsatz gelangen können, wie solche auf Zinn-Zink-Basis, Zinn-Silber-Basis oder auch aus reinem Zinn.

In Weiterbildung ist vorgesehen, dass zur Vermeidung einer Durchkontaktierung (Shunt) der auf der Oberseite einer Solarzelle verlaufenden Oberflächenschicht wie SiNₓ-Schicht bei einer niedrigen Sonotrodenfrequenz, vorzugsweise im Bereich zwischen 10 kHz und 40 kHz gearbeitet wird. Ferner ist insbesondere vorgesehen, dass die Sonotrodenlängsachse zur von der Oberfläche des Werkstücks wie Solarzelle ausgehenden Normalen einen Winkel < 90° einschließt, wobei eine vollständige horizontale Ausrichtung, also horizontale Einkopplung möglich ist.

Ferner besteht die Möglichkeit, gezielt die Schwingung der Sonotrode von der Resonanzfrequenz abweichen zu lassen. Dies kann durch Verstimmung der Sono-trode oder durch eine Sonotrodenlänge erreicht werden, die von einem ganzzahligen λ/2 abweicht, wobei λ Amplitude der Ultraschallschwingung ist.

Die Auftragsgeschwindigkeit des Lots sollte im Bereich zwischen 0,1 mm/sec und 200 mm/sec, insbesondere zwischen 20 mm/sec und 80 mm/sec liegen.

Des Weiteren besteht die Möglichkeit, mittels des erfindungsgemäßen Verfahrens Lotbänder aufzubringen, die die Funktion von Busbars ausüben, die üblicherweise auf Solarzellen aufgetragen werden. Dabei besteht die Möglichkeit, z. B. zwei oder mehr Busbars vorzugsweise aus Zinn auf der Vorderseite einer Solarzelle aufzubringen. Die die Funktion von Busbars ausübenden Lotbahnen sollten dabei Breiten zwischen 0,5 mm und 15 mm, vorzugsweise im Bereich von 2 mm aufweisen.

Zur Erzielung einer hinreichenden Prozessstabilität ist des Weiteren vorgesehen, dass das verwendete Ultraschallsystem ununterbrochen aktiv ist, also die Sonotrode fortwährend schwingt, um evtl. auftretende Resonanzabweichungen beim Ansteuern des Ultraschallsystems zu vermeiden. Eine ununterbrochene Schwingungserregung zeigt des Weiteren den Vorteil, dass lotbedingte Benetzungseigenschaften in der Heizzone zwischen der Heizeinrichtung und der Sonotrode stabilisiert werden.

Besonders vorteilhaft ist des Weiteren, dass ein Verkrusten im Bereich der Zuführung des geschmolzenen Lotes problemlos beseitigt werden kann, indem nach Beloten eines Werkstücks oder einer vorgegebenen Anzahl von Werkstücken der Spalt durch Beaufschlagen mit einem Abblasimpuls gereinigt wird. Dies erfolgt dann, wenn die die Heizeinrichtung und die Sonotrode umfassende Vorrichtung angehoben wird, um ein neues Werkstück in den Bereich der Sonotrode zu positionieren.

Insbesondere erfolgt das Abblasen mittels eines Gases wie N₂, Luft, Argon oder anderen geeigneten Inertgasen. Es kann jedoch auch ein Spülen mit einer Flüssigkeit vorgenommen werden.

Alternativ oder ergänzend kann eine Reinigungseinrichtung vorgesehen werden, um z. B. mittels rotierender Bürsten oder sonstiger geeigneter Elemente den Spalt zwischen der Sonotrode und der Heizeinrichtung von z. B. lotbedingten Verkrustungen zu befreien. Auch besteht die Möglichkeit, eine Absaugeinrichtung anzuordnen, um Verschmutzungen zu entfernen.

In weiterer Ausbildung der Erfindung wird als Heizeinrichtung ein blockförmiger eine hohe Wärmekapazität aufweisender Körper verwendet, der gewährleistet, dass im Bereich des Spaltes eine gewünschte gleichbleibende Temperatur herrscht. Dabei kann der block- oder quaderförmige Heizkörper derart zur Sonotrode ausgerichtet werden, dass die Längsachse des Heizkörpers zur Oberfläche des Werkstücks ausgehend vom sonotrodennahen Ende einen spitzen Winkel bis zu 20°, vorzugsweise im Bereich von 0° bis 50° einschließt. Hierdurch ist sichergestellt, dass ein unerwünschtes Aufheizen des Werkstückes unterbleibt, da die Unterseite des Heizkörpers geneigt zur Werkstückoberfläche zur Erzielung eines hinreichenden Abstands verläuft.

Der Spalt wird vorzugsweise von einem zylinderabschnittsförmigen Vorsprung des Heizkörpers begrenzt, wobei der Spalt über seine Höhe eine gleiche Quererstreckung - quer zur Auftragsrichtung des Lots - aufweisen und sich in Richtung des Werkstücks konisch erweitern kann, also in Auftragsrichtung des Lots. Eine konstante Breite über die Hälfte des Spalts ist gleichfalls möglich.

Eine Vorrichtung der eingangs genannten Art zeichnet sich dadurch aus, dass die Heizzone einen Spalt umfasst, der durch die Heizeinrichtung und die Ultraschallsonotrode begrenzt ist, wobei der Spalt Zuführung für das Lot zum Werkstück ist. Insbesondere ist vorgesehen, dass der Spalt zwischen der Sonotrode und der Heizeinrichtung vorzugsweise eine Breite B mit ½ D ≤ B ≤ D aufweist, wobei D = Durchmesser des Lotdrahts ist.

Der Spalt kann über seine Höhe eine konstante Breite aufweisen. Es besteht jedoch auch die Möglichkeit, dass sich der Spalt in Richtung des Werkstückes konisch erweitert.

Bei der Heizeinrichtung handelt es sich insbesondere um einen mit Heizpatronen bestückbaren quaderförmigen Körper, der sonotrodenseitig einen Vorsprung aufweist, der insbesondere eine Zylinder- wie Halbzylinder-Geometrie aufweist.

Der block- bzw. quaderförmige Heizkörper ist des Weiteren bevorzugterweise derart zu dem Werkstück ausgerichtet, dass ausgehend von der Sonotrode die Unterseite der Heizeinrichtung zu dem Werkstück einen spitzen Winkel einschließt, der in etwa bis 20° betragen kann. Bevorzugterweise sollte der Winkel zwischen 0° und 50° liegen. Hierdurch erfolgt eine Beabstandung zwischen Heizeinrichtung und dem Werkstück mit der Folge, dass dieses nicht unerwünscht erhitzt wird.

Die Sonotrode, die ebenfalls auf eine Temperatur oberhalb des Schmelzpunktes des Lotmaterials erhitzt wird, wird des Weiteren oberhalb der Heizeinrichtung von einem thermisch isolierenden Rohr wie Keramikrohr umgeben.

Des Weiteren ist eine Reinigungseinrichtung vorgesehen, über die ein Abblasimpuls zum Reinigen der Heizzone, also des Spaltbereichs erfolgt. Als Reinigungsmedium kann Flüssigkeit oder Gas wie N₂, Luft, Argon oder ein sonstiges Inertgas benutzt werden.

Alternativ oder ergänzend besteht die Möglichkeit, der Sonotrode und der Heizeinrichtung eine Reinigungseinrichtung zuzuordnen, um den Spalt bzw. die Heizzone zu reinigen. Somit können problemlos lotbedingte Verkrustungen zwischen der Heizeinrichtung bzw. dem Heizkörper und der Sonotrode entfernt werden.

Mittels einer Absaugvorrichtung können ebenfalls lotbedingte Verschmutzungen entfernt werden.

Weitere Einzelheiten, Vorteile und Merkmale der Erfindung ergeben sich nicht nur aus den Ansprüchen, den diesen zu entnehmenden Merkmalen - für sich und/oder in Kombination-, sondern auch aus der nachfolgenden Beschreibung eines der Zeichnung zu entnehmenden bevorzugten Ausführungsbeispiels.

Es zeigen:
- Fig. 1: einen Ausschnitt einer Vorrichtung zum Aufbringen eines Lotmaterials auf ein Werkstück,
- Fig. 2: den Ausschnitt der Vorrichtung gemäß Fig. 1 um 90° gedreht,
- Fig. 3: den Ausschnitt der Vorrichtung gemäß Fig. 1 und 2 in Unteransicht,
- Fig. 4: einen Ausschnitt aus der Fig. 3 in vergrößerter Darstellung und
- Fig. 5: Prinzipdarstellungen eines mit Lotmaterial benetzten und unbenetzten Spalts.

Den Figuren sind ein Ausschnitt bzw. Details einer Vorrichtung zu entnehmen, mittels der auf ein Werkstück 10 ein vorzugsweise streifenförmiger Lotstreifen aufgebracht wird. Bei dem Werkstück 10 handelt es sich insbesondere um ein Halbleiterbauelement wie Solarzelle, um nach Aufbringen des Lotmaterials auf diesem z. B. elektrische Kontakte aufzulöten. Hierbei kann es sich um Zellverbinder handeln.

Das Aufbringen des Lotmaterials kann auch derart erfolgen, dass sich Lotstreifen ausbilden, die die Funktion von Busbars ausüben, die auf Solarzellen aufgebracht und insbesondere mit Stromsammlern (Gridfingern) verbunden werden.

Um das Lot auf das Werkstück 10 aufzubringen, wird von einer nicht dargestellten Lotdrahtzuführeinrichtung Lotdraht 12 einer Heizzone 14 zugeführt, die zwischen einer Heizeinrichtung 16 und einer Sonotrode 18 einer Ultraschallvorrichtung verläuft.

In den Figuren ist die Sonotrode 18, die eine Stabgeometrie aufweist, oberhalb der Heizeinrichtung 16 von einem Keramikrohr 20 mit Heizdraht umgeben, um die Sonotrode auf eine Temperatur oberhalb des Schmelzpunkts des Lotmaterials aufzuheizen. Die Sonotrode 18 geht des Weiteren in bekannter Weise von einem Ultraschallgeber 22 aus, über den die Sonotrode 18 in Ultraschallschwingungen im Bereich zwischen 10 kHz und 80 kHz, insbesondere zwischen 10 kHz und 40 kHz angeregt wird, um nur beispielhaft Zahlen zu nennen.

Bei der Heizeinrichtung 16 handelt es sich im Ausführungsbeispiel um einen quader-oder blockartigen Heizkörper 17, der mit Heizpatronen bestückt ist. Dabei weist der Heizkörper 17 eine hohe Wärmekapazität auf, um im Bereich der Heizzone 14 gewünschte konstante Temperaturen sicherzustellen.

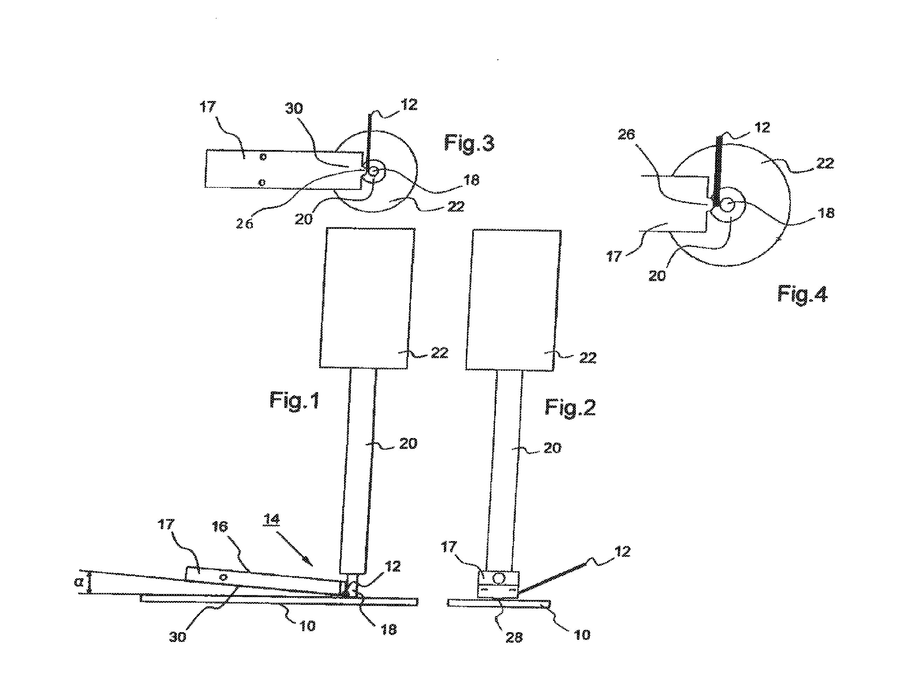

In die Heizzone 14 wird der Lotdraht 12 eingeführt, und zwar im Ausführungsbeispiel schräg von der Seite, wie ein Vergleich der Figuren prinzipiell verdeutlicht. Hierdurch soll jedoch die erfindungsgemäße Lehre nicht eingeschränkt werden. Erfindungsgemäß weist die Heizzone 14 einen Spalt 24 auf, der einerseits von der Sonotrode 18 und andererseits von einem vorzugsweise halbzylinderförmigen Vorsprung 26 der Heizeinrichtung 16 bzw. des Heizkörpers 17 begrenzt wird, wie sich aus den Fig. 3 und 4 ergibt. Allerdings ist es nicht zwingend erforderlich, dass der Heizkörper 17 einen entsprechenden Vorsprung aufweist. Vielmehr kann der Heizkörper 17 sonotrodenseitig eine glatte Fläche aufweisen, die gleichfalls einen entsprechenden Spalt begrenzt.

Bevorzugterweise geht jedoch von der der Sonotrode 18 zugewandten Fläche des Heizkörpers 17 der Vorsprung 26 aus, der jedoch auch eine andere als die der Zeichnung zu entnehmende im Schnitt eine Kreisabschnittsgeometrie aufweisende Geometrie besitzen kann.

Wie die Fig. 4 verdeutlicht, ist die Spaltbreite B, also der lichte Abstand zwischen der Sonotrode 18 und dem Vorsprung 26 derart gewählt, dass dieser vorzugsweise zwischen 1/2 D und D mit D = Durchmesser des Lotdrahtes liegt. Die Breite B erstreckt sich in Auftragsrichtung des Lots 10 auf das Werkstück, also in Fig. 1 in der Zeichenebene und parallel zu dem dargestellten Abschnitt des Werkstücks 10. Die Breite B kann konstant sein oder sich in Richtung des Werkstücks konisch erweitern.

Sowohl der Heizkörper 17 als auch die Sonotrode 18 werden auf eine Temperatur eingestellt, die oberhalb der Schmelztemperatur des Lotdrahtes 12 liegt. Vorzugsweise wird Lotmaterial benutzt, das im Bereich zwischen 100 °C und 350 °C schmilzt, gleichwenn der Temperaturbereich zwischen 80 °C und 600 °C liegen kann. Die Temperatureinstellung des Heizkörpers 17 im Bereich seines Vorsprungs 26 erfolgt dabei unabhängig von der Einstellung der Temperatur der Sonotrode 18.

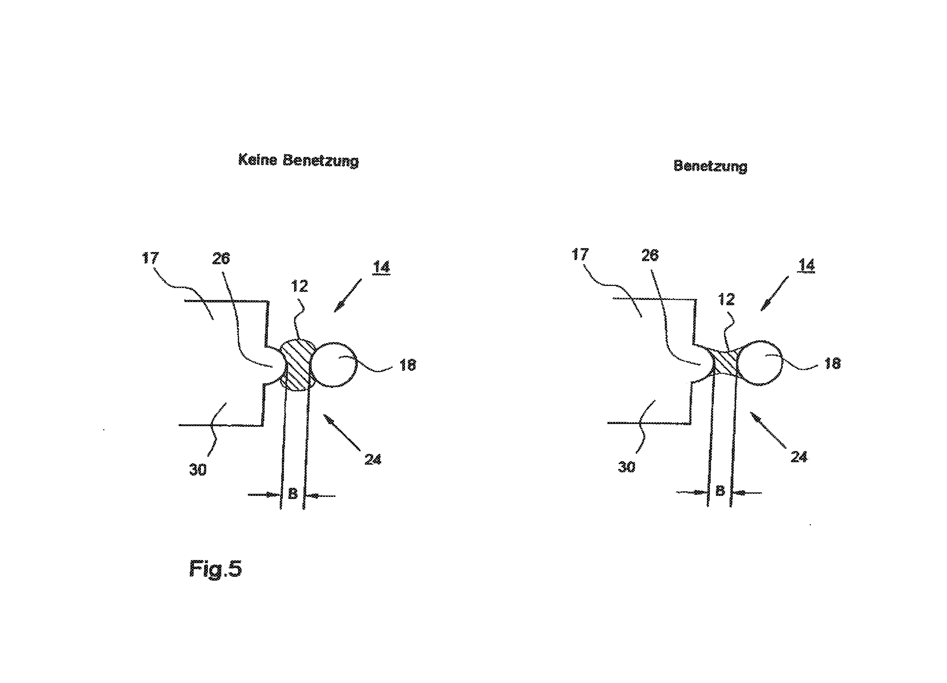

Erfindungsgemäß wird der Lotdraht 12 in der Heizzone 14 dem Spalt 24 zugeführt. Dabei schmilzt der Lotdraht. Ungeachtet der hohen Oberflächenspannung erfolgt ein Benetzen der Begrenzung des Spalts 24 (s. rechte Darstellung in Fig. 5) durch die in Ultraschallschwingung erregte Sonotrode 18 mit der Folge, dass das geschmolzene Lot durch den Spalt 24 auf die Oberfläche des Werkstücks 10 fließt und sodann das auf das Werkstück 10 aufgebrachte Lot über die dem Werkstück 10 zugewandte flache Stirnfläche 28 der Sonotrode 18 mit Ultraschall beaufschlagt wird, um das Beloten des Werkstücks 10 sicherzustellen. Im Bereich der Stirnfläche 28 verläuft der Schwingungsbauch der erregten Sonotrode 18.

In der linken Darstellung in Fig. 5 ist das geschmolzene Lot bei nicht in Schwingung versetzter Sonotrode 18 dargestellt.

Wie sich aus den Fig. 1 und 2 ergibt, ist der quaderförmige oder blockartige Heizkörper 17 mit seiner Unterseite 30 derart zur Werkstückoberfläche ausgerichtet, dass sich von der Sonotrode 18 ausgehend ein spitzer Winkel α ergibt, der zwischen 0° und 20°,insbesondere zwischen 0° und 50° liegen sollte. Hierdurch wird zusätzlich sichergestellt, dass das Werkstück 10 nicht unerwünscht über den Heizkörper 17 aufgeheizt wird.

Der Spalt 24 kann über dessen Höhe eine konstante Breite aufweisen. Es besteht jedoch auch die Möglichkeit, dass sich der Spalt in Richtung des Werkstücks 10 vergrößert, insbesondere dann, wenn der Bereich des Spaltes 24, der von dem Heizkörper 17 begrenzt wird, sich senkrecht zur Unterseite 30 des Heizkörpers 17 erstreckt.

Des Weiteren ist erfindungsgemäß vorgesehen, dass unter Benutzung einer nicht dargestellten Reinigungseinrichtung nach Anheben der Ultraschallvorrichtung mit der Heizeinrichtung 16 ein Abblasimpuls zum Reinigen des Spaltbereichs abgegeben wird. Hierbei kann es sich um ein Gas oder eine Flüssigkeit handeln, die impulsartig den Spaltbereich beaufschlagt, so dass lotbedingte Verkrustungen entfernt werden.

Alternativ oder ergänzend kann eine mechanische Reinigungseinrichtung vorgesehen werden, um lotbedingte Verkrustungen zu entfernen. Hierbei kann es sich um rotierende Bürsten oder andere gleichwirkende ein Entfernen der Verkrustungen ermöglichende Elemente handeln.

Ferner kann eine Absaugvorrichtung vorgesehen sein um lotbedingte Verschmutzungen aufzufangen bzw. absaugen zu können.

Um eine Prozessstabilität zu erzielen, kann die Sonotrode fortwährend erregt bleiben, auch dann, wenn ein Lotdraht nicht zugeführt wird. Hierdurch wird sichergestellt, dass Resonanzabweichungen vermieden werden. Auch werden lotbedingte Benetzungseigenschaften im Spalt stabilisiert.

Die Auftragsgeschwindigkeit des Lots auf das Werkstück 10 sollte im Bereich zwischen 2 mm und 200 mm, vorzugsweise zwischen 20 mm und 80 mm/sec liegen.

Ist im Ausführungsbeispiel die Sonotrodenlängsrichtung entlang der von dem Werkstück 10 ausgehenden Normalen ausgerichtet, so sind andere Winkel gleichfalls möglich. Insbesondere ist eine schräge Einkopplung des Ultraschalls möglich. Dies heißt, dass die Längsachse der Sonotrode 18 zu der von dem Werkstück 10 ausgehenden Normalen einen Winkel > 0° einschließt. Dabei kann ggfs. eine Ausrichtung parallel zu der Oberfläche des Werkstücks 10 erfolgen. Entsprechend muss die Sonotrodenspitze bzw. die zugeordnete Fläche des Heizkörpers 17 ausgebildet werden, um den erforderlichen Spalt für den Lotdraht zur Verfügung zu stellen.

Die Erfindung wird auch dann nicht verlassen, wenn eine gezielte Abweichung der Resonanzfrequenz z. B. durch Verstimmung der Sonotrode 18 oder durch Einsatz einer Sonotrode 18 einer Länge erfolgt, die von einem ganzzahligen λ/2 mit λ = Amplitude abweicht.

Die Sonotrode 18 sollte im Bereich des Spalts eine Zylindergeometrie aufweisen mit einem Durchmesser, der zwischen 0,5 mm und 4 mm, bevorzugterweise zwischen 1 mm und 2 mm liegt.

## Patentansprüche

1. Verfahren zum Aufbringen von Lot auf ein Werkstück (10), vorzugsweise auf ein Halbleiterbauelement wie Solarzelle, wobei unter Verwendung eines Lotdrahts dieser im geschmolzenen Zustand auf das Werkstück unter Einwirkung von von einer Sonotrode (18) applizierten Ultraschallschwingungen aufgebracht wird, **dadurch gekennzeichnet,**
**dass** der Lotdraht einem zwischen einer Heizeinrichtung (16, 17) und der die Ultraschallschwingungen applizierenden Sonotrode (18) verlaufenden Spalt (24) zugeführt und geschmolzen wird und durch den Spalt auf das Werkstück (10) fließt.

2. Verfahren nach Anspruch 1,
**dadurch gekennzeichnet,**
**dass** der Spalt (24) zwischen der Sonotrode (18) und der Heizeinrichtung (16, 17) auf eine Breite B mit ½ D ≤ B ≤ D, mit D = Durchmesser des Lotdrahts, eingestellt wird.

3. Verfahren nach Anspruch 1 oder 2,
**dadurch gekennzeichnet,**
**dass** die Sonotrode (18) und die Heizeinrichtung (16, 17) jeweils auf eine Temperatur oberhalb der Schmelztemperatur des Lots erwärmt wird, wobei vorzugsweise die Temperatur der Heizeinrichtung unabhängig von der Temperatur der Sonotrode eingestellt wird.

4. Verfahren nach zumindest einem der vorhergehenden Ansprüche,
**dadurch gekennzeichnet,**
**dass** als Heizeinrichtung (16, 17) ein block- oder quaderförmiger Heizkörper verwendet wird, der sonotrodenseitig vorzugsweise einen den Spalt (24) begrenzenden Vorsprung (26) aufweist, der bevorzugterweise eine Zylinderabschnittsgeometrie aufweist.

5. Verfahren nach zumindest einem der vorhergehenden Ansprüche,
**dadurch gekennzeichnet,**
**dass** die Heizeinrichtung (16, 17) bzw. der Vorsprung (26) zu der Sonotrode (18) derart ausgerichtet wird, dass der Spalt (24) über seine Höhe eine gleiche Breite aufweist oder sich in Richtung des Werkstücks (10) erweitert.

6. Verfahren nach zumindest einem der vorhergehenden Ansprüche,
**dadurch gekennzeichnet,**
**dass** nach Auftragen von Lot auf ein Werkstück (10) und vor Auftragen von Lot auf ein weiteres Werkstück der Spalt (24) vorzugsweise durch impulsartige Beaufschlagung einer Flüssigkeit oder eines Gases wie Luft, N₂, Argon oder eines sonstigen Inertgases gereinigt wird.

7. Verfahren nach zumindest einem der vorhergehenden Ansprüche,
**dadurch gekennzeichnet,**
**dass** als Lotmaterial ein solches benutzt wird, das auf einer Sn-Zn-Basis, Sn-Ag-Basis oder aus insbesondere reinem Zinn besteht.

8. Verfahren nach zumindest einem der vorhergehenden Ansprüche,
**dadurch gekennzeichnet,**
**dass** die Sonotrode (18) mit ihrer Längsachse zur von der Werkstückoberfläche ausgehenden Normalen einen Winkel α mit 0° < α ≤ 90° einschließt.

9. Verfahren nach zumindest einem der vorhergehenden Ansprüche,
**dadurch gekennzeichnet,**
**dass** das Aufbringen des Lots mit einer Geschwindigkeit V mit 0,1 mm/s ≤ V ≤ 200 mm/s, insbesondere 20 mm/s ≤ V ≤ 80 mm/s erfolgt.

10. Verfahren nach zumindest einem der vorhergehenden Ansprüche,
**dadurch gekennzeichnet,**
**dass** als Werkstück (10) eine Solarzelle verwendet wird, auf die das Lot als Busbar aufgetragen wird, insbesondere mit einer Breite A mit 0,5 mm ≤ A ≤5 mm, vorzugsweise A ≈ 2 mm.

11. Verfahren nach zumindest einem der vorhergehenden Ansprüche,
**dadurch gekennzeichnet,**
**dass** zur Prozessstabilität die Sonotrode (18) bei unterbrochener Zuführung des Lotdrahts in Schwingung erregt bleibt und/oder dass die Sonotrode mit einer von ihrer Resonanzfrequenz abweichenden Frequenz in Schwingung versetzt wird.

12. Vorrichtung zum Aufbringen eines Lots auf ein Werkstück (10), insbesondere auf ein Halbleiterbauelement wie Solarzelle, umfassend eine Lotdrahtzuführungseinrichtung, eine Heizeinrichtung (16, 17), eine Ultraschall applizierende Ultraschallsonotrode (18) sowie eine Transporteinrichtung zum Transport des Werkstücks relativ zu sowohl der Heizeinrichtung als auch der Sonotrode, wobei der Lotdraht in einer der Heizeinrichtung zugeordneten Heizzone (14) geschmolzen wird, **dadurch gekennzeichnet,**
**dass** die Heizzone (14) einen Spalt (24) umfasst, der von der Sonotrode (18) und der Heizeinrichtung (16, 17) begrenzt ist und Zuführung für das Lot zum Werkstück (10) ist.

13. Vorrichtung nach Anspruch 12,
**dadurch gekennzeichnet,**
**dass** die Heizeinrichtung (16) ein block- oder quaderförmiger Heizkörper (17) ist, der sonotrodenseitig einen den Spalt (24) begrenzenden Vorsprung (26) aufweist, der vorzugsweise eine Zylinderabschnittsgeometrie aufweist, wobei vorzugsweise der Heizkörper (17) mit seiner Unterseite (30) zur Oberfläche des Werkstücks (10) ausgehend von der Sonotrode (18) einen spitzen Winkel α mit insbesondere 0° < α ≤ 20°, vorzugsweise 0° < α ≤ 5°, einschließt.

14. Vorrichtung nach Anspruch 12 oder 13,
**dadurch gekennzeichnet,**
**dass** der Spalt (24) über seine Höhe eine konstante Breite B aufweist oder sich in Richtung des Werkstücks (10) vergrößert.

15. Vorrichtung nach zumindest einem der Ansprüche 12 bis 14,
**dadurch gekennzeichnet,**
**dass** die Vorrichtung eine Reinigungseinrichtung umfasst, über die impulsartig dem Spalt (24) ein Reinigungsmedium wie N₂, Luft, Argon, Inertgas oder Flüssigkeit zuführbar ist und/oder dass der Vorrichtung eine Reinigungseinrichtung zugeordnet ist, über die der Spalt mechanisch z. B. mittels rotierender Bürsten reinigbar ist und/oder dass die Vorrichtung eine Absaugvorrichtung zum Absaugen lotbedingter Verschmutzungen umfasst.
